# EUROPEAN PATENT APPLICATION

(11) **EP 1 708 202 A2**
(43) Date of publication of application: **04.10.2006**
(21) Application number: 06004893.1
(22) Date of filing: 10.03.2006
(51) Int. Cl.: G11C 16/02, G11C 16/08, G11C 16/24

(54) **Pram device**

(30) Priority: 24.03.2005 KR 2005024541; 06.02.2006 US 348432
(71) Applicant: Samsung Electronics Co., Ltd., Suwon-si, Gyeonggi-Do (KR)
(72) Inventor: Cho, Beak-hyung, Hwaseong-si Gyeonggi-do (KR); Kim, Du-eung, Suji-eub Yongin-si Gyeonggi-do (KR); Kwak, Choong-keun, Yeongtong-gu Suwon-si Gyeonggi-do (KR); Cho, Woo-yeong, Yeongtong-gu Suwon-si Gyeonggi-do (KR); Oh, Hyung-rok, Taean-eub Hwaseong-si Gyeonggi-do (KR)
(74) Representative: Weller, Erich W.

(57) **Abstract**

A phase-changeable random access memory (PRAM) device according to the invention includes a plurality of rows and columns of PRAM memory cells therein and at least one local bit line electrically coupled to a column of the PRAM memory cells. First and second bit line selection circuits are provided to increase the rate at which the at least one local bit line can be accessed and driven with a bit line signal. These first and second bit line selection circuits are configured to electrically connect first and second ends of the at least one local bit line to a global bit line during an operation to read data from a selected one of the PRAM memory cells in the column. Additionally, a local word line is driven from both ends at a time, thereby increasing driving capability and reducing access time.

## Description

The invention relates to a phase-changeable random access memory (PRAM) device. This application claims priority to Korean Application No. 2005-0024541, filed March 24, 2005, the disclosure of which is hereby incorporated herein by reference.

PRAM devices are one class of nonvolatile memory devices which offer many advantageous electrical characteristics relatively to other non-volatile memory devices such as flash memory, static random access memory (SRAM), and dynamic random access memory (DRAM) devices. PRAM devices support non-volatile data storage, random access addressing and relatively high speed read and write operations. PRAM devices may also be configured to have relatively low power consumption requirements.

The nonvolatile characteristics of the PRAM devices may be provided by configuring each memory cell with a chalcogenide alloy (e.g., GST: Ge₂Sb₂Te₅) having programmable resistivity characteristics. For example, during a write/programming operation, the chalcogenide alloy within a memory cell may undergo resistive heating to thereby alter the resistivity of the chalcogenide alloy and cause the memory cell to be "set" into one logic state or "reset" into another logic state.

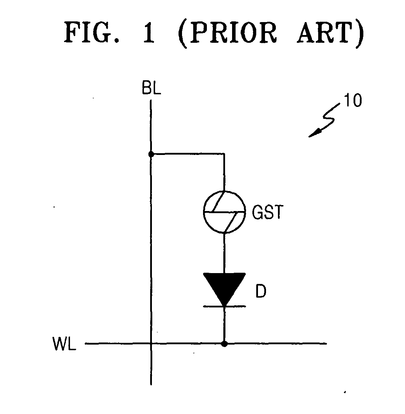

FIG. 1 illustrates a conventional diode-type PRAM cell 10, which is electrically coupled to respective bit and word lines (BL and WL). In this PRAM cell 10, the chalcogenide alloy (e.g., GST alloy) may be programmed to have a relatively high resistance state (high-R state) or a relatively low resistance state (low-R state). This state may be detected during a reading operation by biasing the bit line BL at a higher voltage relative to the word line to thereby establish a forward current path through the PRAM cell 10. The magnitude of the established current (e.g., bit line current) in the forward current path is measured to determine the state (high-R or low-R) of the cell 10.

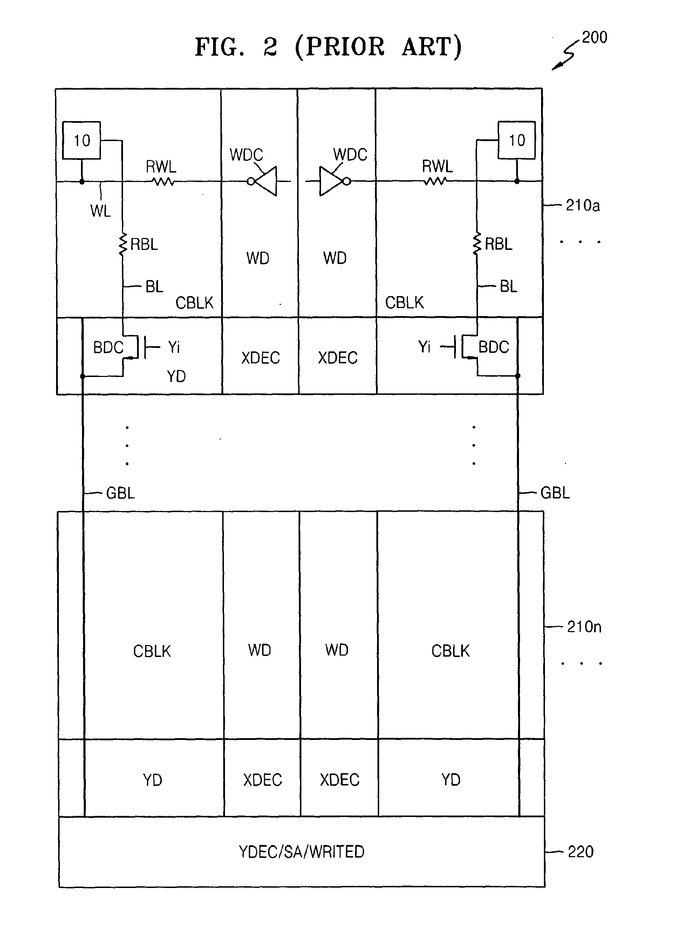

FIG. 2 illustrates a conventional memory device 200 having a plurality of PRAM memory blocks 210a to 210n therein that are electrically coupled to a column decoder/driver circuit 220. Each of these PRAM memory blocks 210a to 210n is illustrated as including a plurality of memory cell blocks CBLK, word line drivers WD, row decoders XDEC and local bit line selection circuits YD therein. Each memory cell block CBLK includes a two-dimensional array of PRAM cells 10 C spanning multiple columns and rows. Each row within the cell block CBLK is associated with a corresponding local word line WL and each column is associated with a corresponding local bit line BL. The word lines are driven by a word line driver WDC, which is shown as an inverter having an output electrically coupled to one end of a local word line WL. The local bit lines BL are electrically coupled to a bit line selection circuit BDC, which is shown as an NMOS transistor having a gate terminal responsive to a column selection signal Yi and a source terminal electrically coupled to a corresponding global bit line GBL. The global bit lines GBL are controlled by the column decoder/driver circuit 220, containing a column decoder YDEC, sense amplifier SA and write driver WRITED therein. Because the size of each memory cell block CBLK is a function of the drive characteristics of each word line driver WD and bit line selection circuit YD, the resistance of each local word line RWL and the resistance of each local bit line RBL may indirectly influence the capacity of the memory device 200 for a given layout area.

To improve PRAM device performance, some techniques have been developed to reduce local word line resistance. One such technique is disclosed in Laid-Open Publication US 2005/0270883 A1. As illustrated by FIG. 4 there, a relatively long global word line may be replaced by a plurality of shorter local word lines (e.g., LWL0, LWL1 and LWL2) that are connected to respective pull-down switching devices (e.g., NMOS transistors N101, N102, N103, ..., N106). These pull-down switching devices have gate terminals responsive to global word line signals (e.g., SWL0, SWL1 and SWL2). An additional technique is disclosed in Patent Publication US 6,480,438. In this publication, bit line and word line compensation circuits are used to minimize resistance variations across the cells of an array to thereby provide equivalent cell programming conditions. Additional PRAM devices are disclosed in an article by W.Y. Cho et al., entitled "A 0.18um 3.0V 64Mb Non-Volatile Phase-Transition Random-Access Memory (PRAM)", Digest of the IEEE International Solid-State Circuits Conference, Session 2, Paper 2.1, pp. 1-2, February 16, 2004. Patent Publication US 6,791,867 discloses a non-volatile memory device having memory cells therein with programmable resistance states and shunt elements connected in series within controlled current paths. Additional PRAM devices are disclosed in Laid-Open Publications US 2005/0030814 and US 2004/0246808 as well as Patent Publication US 6,487,113.

It is the technical problem underlying the invention to provide a PRAM device which is capable of reducing or avoiding the inconveniences of the prior art mentioned above and in particular allows for an enhanced bit line and/or word line driving capability.

The invention achieves this problem by providing a PRAM device having the features of claim 1 or 2. Advantageous embodiments of the invention are mentioned in the dependent claims the wording of which is herewith incorporated into the specification by reference to avoid unnecessary text repetition.

Embodiments of the invention include phase-changeable random access memory (PRAM) devices having enhanced bit line and/or word line driving capability that supports high bit line and/or word line slew rates during programming and reading operations. These embodiments may include a PRAM memory array having a plurality of rows and columns of PRAM memory cells therein and at least one local bit line electrically coupled to a column of PRAM memory cells in the PRAM memory array. First and second bit line selection circuits are also provided to increase the rate at which the at least one local bit line can be accessed and driven with a bit line signal. These first and second bit line selection circuits are configured to electrically connect first and second ends of the local bit line to a global bit line during an operation to read data from a selected one of the PRAM memory cells in the column. The first and second bit line selection circuits are further configured to electrically connect the first and second ends of the local bit line to the global bit line during an operation to write data to a selected one of the PRAM memory cells in the column. The first and second bit line selection circuits are responsive to equivalent column selection signals.

Still further embodiments of the invention include a phase-changeable random access memory (PRAM) device having at least one local word line electrically coupled to a row of PRAM memory cells in a PRAM memory array and first and second word line driver circuits. The first and second word line driver circuits are electrically connected to first and second spaced-apart nodes on the local word line, respectively. The first and second word line driver circuits are configured to drive the first and second spaced-apart nodes at the same voltage level during an operation to read data from a selected one of the PRAM memory cells in the row. In some of these embodiments, the first and second word line driver circuits are electrically connected to a global word line. In additional embodiments of the invention, the local word line spans multiple PRAM memory arrays and the first and second spaced-apart nodes are located at intermediate points along the local word line.

Still further embodiments of the invention include a phase-changeable random access memory (PRAM) device having a PRAM memory array of diode-controlled PRAM memory cells therein. At least one local word line and at least one local bit line are provided in the array. The at least one local word line is electrically coupled to a row of diode-controlled PRAM memory cells in the PRAM memory array and the at least one local bit line is electrically coupled to a column of diode-controlled PRAM memory cells in the PRAM memory array. First and second bit line selection circuits are provided, which are configured to electrically connect first and second ends of the local bit line to a global bit line during an operation to read data from a selected one of the diode-controlled PRAM memory cells in the column. First and second word line driver circuits are also provided, which are electrically connected to first and second spaced-apart nodes on the local word line, respectively. These first and second word line driver circuits are configured to drive the first and second spaced-apart nodes at the same voltage level during an operation to read data from a selected one of the diode-controlled PRAM memory cells in the row. The first and second bit line selection circuits are further configured to electrically connect the first and second ends of the local bit line to the global bit line during an operation to write data to a selected one of the PRAM memory cells in the column. The first and second bit line selection circuits are responsive to equivalent column selection signals. The first and second spaced-apart nodes may be located at opposing ends of the local word line. Alternatively, when the local word line spans multiple PRAM memory arrays, the first and second spaced-apart nodes may be located at intermediate points along the local word line.

Advantageous embodiments of the invention are described in the following and shown in the drawings which also show the conventional embodiments explained above to facilitate the understanding of the invention. In the drawings:
FIG. 1 is an electrical schematic of a conventional diode-type PRAM cell,
FIG. 2 is an electrical schematic of a conventional memory device having a plurality of PRAM memory blocks therein that are electrically connected to a column decoder/driver circuit,
FIG. 3 is an electrical schematic of a multi-block PRAM device according to a first embodiment of the invention,
FIG. 4 is an electrical schematic of a multi-block PRAM device according to a second embodiment of the invention,
FIG. 5 is an electrical schematic of a multi-block PRAM device according to a third embodiment of the invention,
FIG. 6 is an electrical schematic of a multi-block PRAM device according to a fourth embodiment of the invention, and
FIG. 7 is an electrical schematic of a multi-block PRAM device according to a fifth embodiment of the invention.

The invention now will be described more fully herein with reference to the accompanying drawings, in which preferred embodiments of the invention are shown. Like reference numerals refer to like elements throughout and signal lines and signals thereon may be referred to by the same reference characters. Signals may also be synchronized and/or undergo minor boolean operations (e.g., inversion) without being considered different signals.

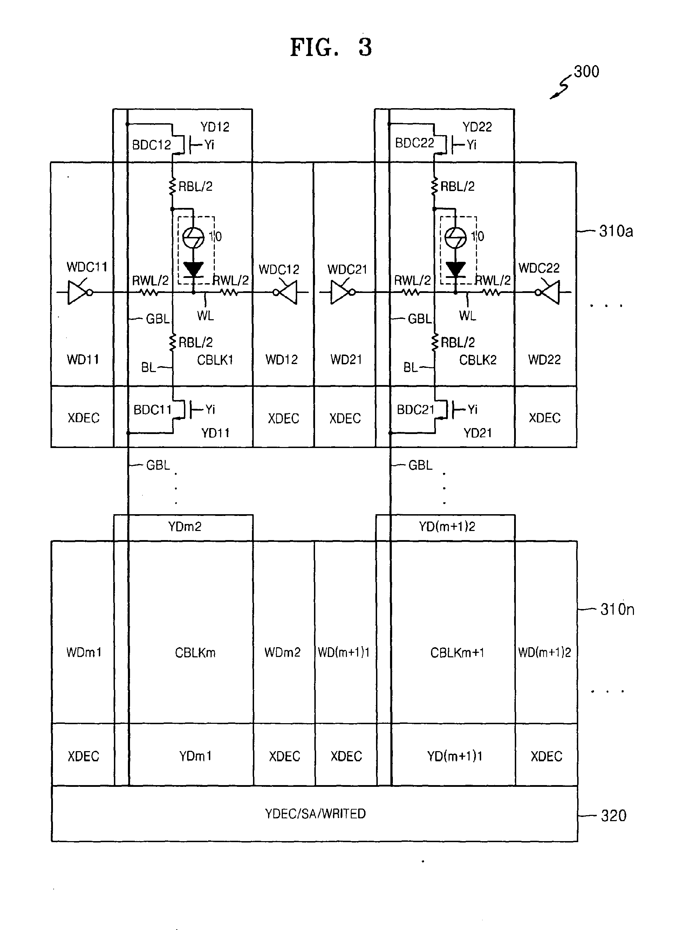

Referring now to FIG. 3, a multi-block PRAM device 300 according to a first embodiment of the invention is illustrated as including a plurality of PRAM memory blocks 310a to 310n that are electrically coupled to a column decoder/driver circuit 320. Each of these PRAM memory blocks 310a to 310n is illustrated as including a plurality of memory cell blocks CBLK1, CBLK2, ... and CBLKm, CBLK(m+1), .... Each of these memory cell blocks is electrically coupled to a corresponding pair of word line driver circuits WD, a pair of row decoders XDEC and a pair of local bit line selection circuits YD therein. In particular, the first memory cell block CBLK1 is electrically coupled in a row direction to a left side word line driver circuit WD11 and a right side word line driver circuit WD12. In addition, the first memory cell block CBLK1 is electrically coupled in a column direction to a bottom bit line selection circuit YD11 and a top bit line selection circuit YD12. A pair of row decoders XDEC are also provided. These row decoders XDEC generate word line driver signals in response to an applied row address.

The first memory cell block CBLK1 includes a two-dimensional array of PRAM cells 10 containing a plurality of rows and columns. These PRAM cells 10 are illustrated as diode-type PRAM cells, however, transistor-controlled PRAM cells (not shown) may also be used. Each column of PRAM cells 10 is coupled to a corresponding local bit line BL and each row of PRAM cells 10 is coupled to a corresponding word line WL. The resistance of each local bit line BL may equal RBL (i.e. ½ RBL + ½ RBL) and the resistance of each local word line WL may equal RWL (i.e. ½ RWL + ½ RWL).

As further illustrated by FIG. 3, each word line is driven by a corresponding pair of word line drivers, which are connected at opposing ends of the respective word line. In particular, the illustrated word line WL is driven by a left side word line driver WDC11 and a right side word line driver WDC12. These drivers are illustrated as inverters. Moreover, each local bit line is driven by a corresponding pair of bit line selection devices, which are connected at opposing ends of the respective local bit line. In particular, the illustrated bit line BL is driven by a bottom bit line selection device BDC11 and a top bit line selection device BDC12. These bit line selection devices are illustrated as NMOS transistors having gate terminals responsive to equivalent column selection signals Yi generated within bottom and top bit line selection YD11, YD12. The drain terminals of the NMOS transistors are connected to a corresponding global bit line GBL, which is controlled by a column decoder/driver circuit 320. The column decoder/driver circuit 320 may be of conventional design.

Similarly, the second memory cell block CBLK2 includes a two-dimensional array of PRAM cells 10 containing a plurality of rows and columns of PRAM cells 10. The second memory cell block CBLK2 is electrically coupled in a row direction to a left side word line driver circuit WD21 and a right side word line driver circuit WD22. The second memory cell block CBLK2 is electrically coupled in a column direction to a bottom bit line selection circuit YD21 and a top bit line selection circuit YD22. In particular, the illustrated word line WL is driven by a left side word line driver WDC21 and a right side word line driver WDC22. The illustrated bit line BL is driven by a bottom bit line selection device BDC21 and a top bit line selection device BDC22. These bit line selection devices are illustrated as NMOS transistors having gate terminals responsive to equivalent column selection signals Yi generated within bottom and top bit line selection circuits YD21, YD22. The drain terminals of the NMOS transistors are connected to a corresponding global bit line GBL, which is controlled by a column decoder/driver circuit 320. The memory cell blocks CBLKm and CBLK(m+1) within the PRAM memory block 310n are configured in a similar manner to the first and second memory cell blocks CBLK1 and CBLK2.

Referring again to the first memory cell block CBLK1, the bottom bit line selection circuit YD11 and the top bit line selection circuit YD12 are configured to electrically connect first and second ends of the local bit line BL to a global bit line GBL during an operation to read data from (or write data to) a selected one of the PRAM memory cells 10 in the corresponding column. This electrical connection is provided by the bottom bit line selection device BDC11 and the top bit line selection device BDC12 when the corresponding column selection signal Yi is switched low-to-high. This dual connection of opposing ends of the local bit line BL to the corresponding global bit line GBL during reading and programming (i.e., writing) operations increases the slew rate of the local bit line signal by reducing the effective resistance of the local bit line BL as seen by the bit line selection devices. This reduction in effective resistance enables the local bit line BL to be longer for a given read/write access time. This ability to support longer local bit lines by using a pair of bit line selection devices on opposing ends of the local bit line enables the use of larger memory cell blocks (e.g., more rows of memory cells).

In a similar manner, the illustrated left side word line driver WDC11 and a right side word line driver WDC12 are configured to drive opposing ends of the corresponding local word line WL at the same voltage level during an operation to read data from (or write data to) a selected one of the PRAM memory cells 10 in the row. This dual connection of opposing ends of the local word line WL during reading and programming (i.e., writing) operations increases the slew rate of the local word line signal and enables the local word line WL to be longer for a given read/write access time. This ability to support longer local word lines by using a pair of word line drivers on opposing ends of the word line enables the use of larger memory cell blocks (e.g., more columns of memory cells).

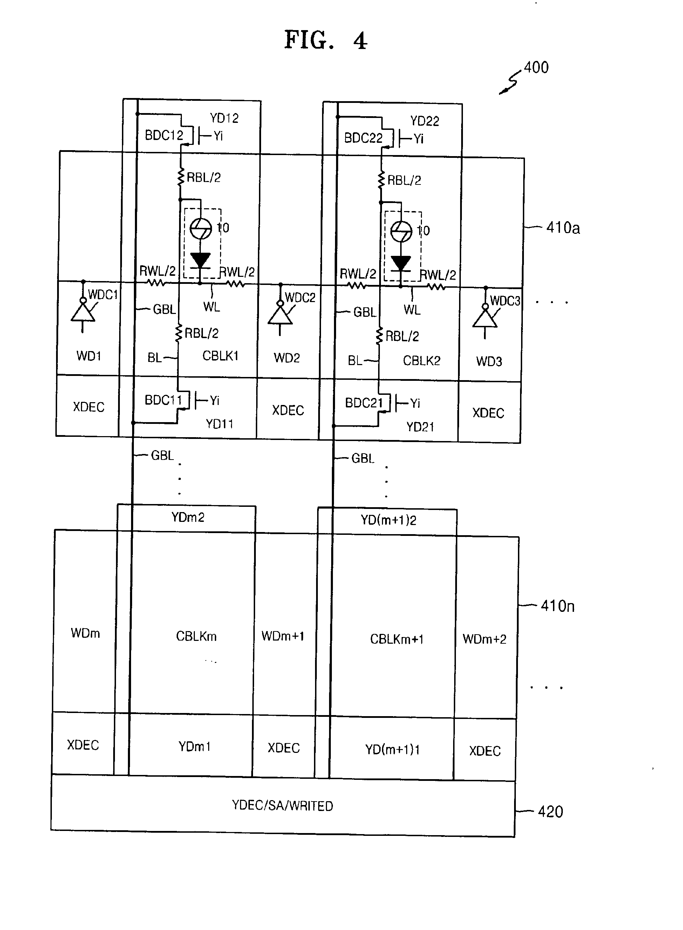

Referring now to FIG. 4, a multi-block PRAM device 400 according to a second embodiment of the invention is illustrated as including a plurality of PRAM memory blocks 410a - 410n that are electrically coupled to a column decoder/driver circuit 420. These PRAM memory blocks 410a - 410n are essentially identical to the PRAM memory blocks 310a - 310n, however, the word line driver circuits WD11, WD12, WD21, WD22, WDm1, WDm2, WD(m+1)1 and WD(m+1)2 illustrated by FIG. 3 are replaced by word line driver circuits WD1, WD2, WD3, WDm, WD(m+1) and WD(m+2). These word line driver circuits include drivers (e.g., WDC1, WDC2, WDC3, ...) having outputs connected to intermediate and spaced-apart nodes of a word line that spans multiple memory cell blocks.

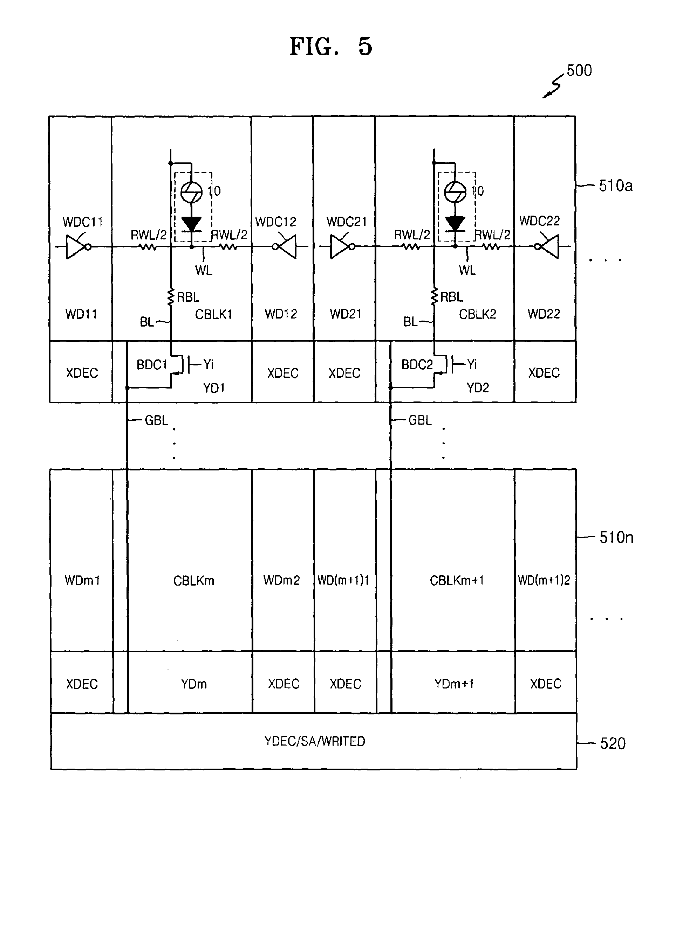

Referring now to FIG. 5, a multi-block PRAM device 500 according to a third embodiment of the invention is illustrated as including a plurality of PRAM memory blocks 510a to 510n that are electrically coupled to a column decoder/driver circuit 520. These PRAM memory blocks 510a to 510n are similar to the PRAM memory blocks 310a to 310n, however, the pairs of bit line selection circuits YD11 and YD12, YD21 and YD22, ... are replaced by single-sided bit line selection circuits YD1, YD2, ..., YDm, YD(m+1) ... containing respective bit line selection devices (e.g., BDC1, BDC2, ...).

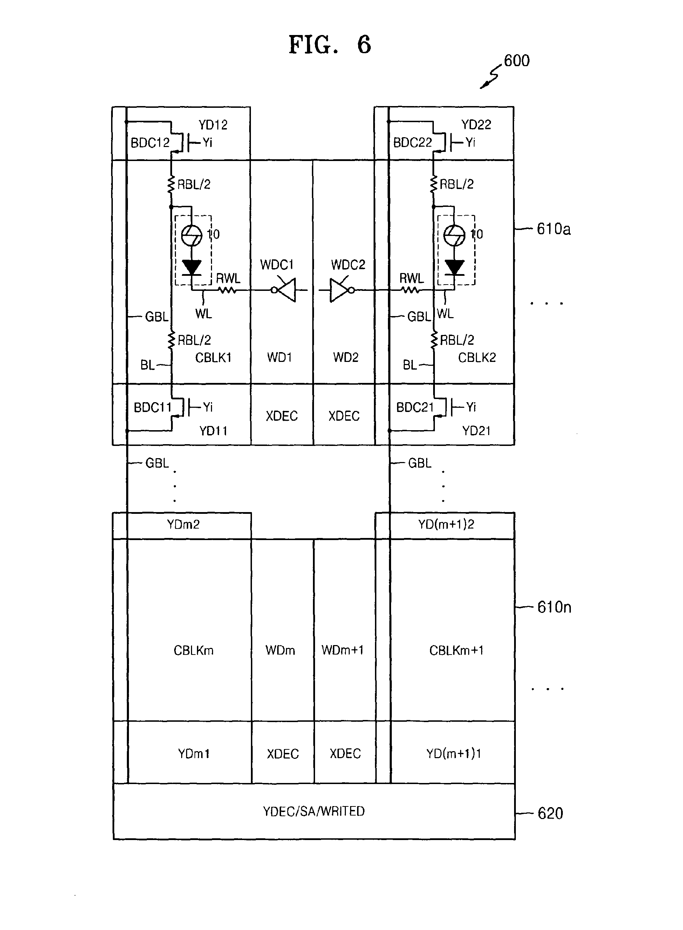

Referring now to FIG. 6, a multi-block PRAM device 600 according to a fourth embodiment of the invention is illustrated as including a plurality of PRAM memory blocks 610a to 610n that are electrically coupled to a column decoder/driver circuit 620. These PRAM memory blocks 610a to 610n are similar to the PRAM memory blocks 310a to 310n of FIG. 3, however, the pairs of word line driver circuits WD11 and WD12, WD21 and WD22 illustrated by FIG. 3 are replaced by single-sided word line driver circuits WD1, WD2, WDm, WD(m+1), ... having respective word line drivers therein (e.g., WDC1, WDC2, ...).

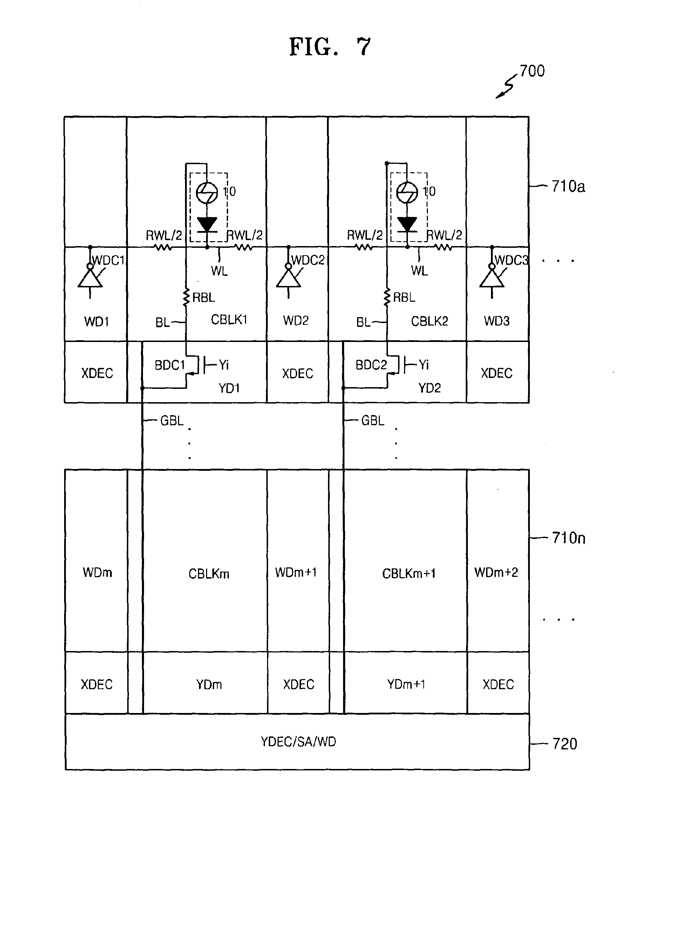

Finally, as illustrated by FIG. 7, which illustrates a multi-block PRAM device 700 according to a fifth embodiment of the invention, the plurality of PRAM memory blocks 410a to 410n illustrated by FIG. 4 are replaced by PRAM memory blocks 710a to 710n, which are electrically coupled to a column decoder/driver circuit 720. The PRAM memory blocks 710a to 710n are similar to the PRAM memory blocks 410a to 410n, however, the pairs of bit line selection circuits YD11 and YD12, YD21 and YD22, ... are replaced by single-sided bit line selection circuits YD1, YD2, ... containing respective bit line selection devices (e.g., BDC1, BDC2, ...).

In the drawings and specification, there have been disclosed typical preferred embodiments of the invention and, although specific terms are employed, they are used in a generic and descriptive sense only and not for purposes of limitation, the scope of the invention being set forth in the following claims.

## Claims

1. A phase-changeable random access memory (PRAM) device, comprising:
a PRAM memory array (10) having a plurality of rows and columns of PRAM memory cells therein; and
a local bit line (BL) electrically coupled to a column of PRAM memory cells in said PRAM memory array;
**characterized by**
first and second bit line selection circuits (BDC11, BDC12) configured to electrically connect first and second ends of said local bit line to a global bit line during an operation to read data from a selected one of the PRAM memory cells in the column.

2. A phase-changeable random access memory (PRAM) device, comprising:
a PRAM memory array (10) having a plurality of rows and columns of PRAM memory cells therein; and
a local word line (WL) electrically coupled to a row of PRAM memory cells in said PRAM memory array;
**characterized by**
first and second word line driver circuits (WDC11, WDC12) electrically connected to first and second spaced-apart nodes on said local word line, respectively, said first and second word line driver circuits configured to drive the first and second spaced-apart nodes at the same voltage level during an operation to read data from a selected one of the PRAM memory cells in the row.

3. The PRAM device of Claim 2, wherein said first and second word line driver circuits are electrically connected to a global word line.

4. The PRAM device of Claim 2 or 3, wherein the first and second spaced-apart nodes are located at opposing ends of the local word line.

5. The PRAM device of any of Claims 2 to 4, wherein the local word line spans multiple PRAM memory arrays and wherein the first and second spaced-apart nodes are located at intermediate points along the local word line.

6. The PRAM device of any of claims 2 to 5, wherein
a local bit line is provided which is electrically coupled to a column of PRAM memory cells in said PRAM memory array; and
first and second bit line selection circuits are provided which are configured to electrically connect first and second ends of said local bit line to a global bit line during an operation to read data from a selected one of the PRAM memory cells in the column.

7. The PRAM device of Claim 1 or 6, wherein said first and second bit line selection circuits are further configured to electrically connect the first and second ends of said local bit line to the global bit line during an operation to write data to a selected one of the PRAM memory cells in the column.

8. The PRAM device of Claim 1, 6 or 7, wherein said first and second bit line selection circuits are responsive to equivalent column selection signals.

9. The PRAM device of any of Claim 1 to 8, wherein the PRAM memory cells are selected from a group consisting of diode-controlled PRAM memory cells and transistor-controlled PRAM memory cells.
